# EUROPEAN PATENT SPECIFICATION

(11) **EP 3 573 046 B1**
(45) Date of publication and mention of the grant of the patent: **07.09.2022**
(21) Application number: 18819669.5
(22) Date of filing: 25.04.2018
(51) Int. Cl.: H01L 27/32, H01L 51/52, H01L 51/56, G09G 3/00, G09G 3/32

(54) **DISPLAY DEVICE COMPRISING A DRIVER CIRCUIT BOARD AND CORRESPONDING METHOD THEREOF**
ANZEIGEVORRICHTUNG MIT TREIBERPLATINE UND VERFAHREN DAFÜR
DISPOSITIF D'AFFICHAGE COMPRENANT UNE CARTE DE CIRCUIT DE COMMANDE ET MÉTHODE CORRESPONDANTE

(30) Priority: 20.06.2017 CN 201710471810
(43) Date of publication of application: 27.11.2019
(73) Proprietor: Kunshan Go-Visionox Opto-Electronics Co., Ltd., KunShan City, Jiangsu 215300 (CN)
(72) Inventor: ZHANG, Jinfang, Kunshan Jiangsu 215300 (CN); ZHANG, Lu, Kunshan Jiangsu 215300 (CN); HAN, Zhenzhen, Kunshan Jiangsu 215300 (CN); HU, Siming, Kunshan Jiangsu 215300 (CN); WANG, Xiangqian, Kunshan Jiangsu 215300 (CN); LIU, Qinggang, Kunshan Jiangsu 215300 (CN); ZHU, Hui, Kunshan Jiangsu 215300 (CN)
(74) Representative: D'Halleweyn, Nele Veerle Trees Gertrudis
(86) International application number: PCT/CN2018/084519
(87) International publication number: WO 2018/233374

(56) References cited:
- EP-A1- 3 376 350
- CN-A- 101 308 267
- CN-A- 101 369 506
- CN-A- 105 845 064
- CN-U- 205 656 393
- CN-U- 207 165 216
- JP-A- 2006 053 338
- JP-B2- 5 017 851
- KR-A- 20150 048 364
- US-A1- 2002 191 140
- US-A1- 2016 379 906

## Description

### TECHNICAL FIELD

The present invention relates to a field of displays, and more particularly, to a display device comprising a driving circuit board, a method for manufacturing the same

### BACKGROUND

A mounting circuit is provided in a substrate non-display region of a screen body of a display device. The mounting circuit generally includes an input pad and an output pad disposed oppositely, with a bare test circuit disposed between the input pad and the output pad. An input pin and an output pin of the integrated circuit chip are connected to the input pad and the output pad respectively, so that the integrated circuit chip is electrically connected to the substrate.

The test circuit is easily damaged and particularly easy to be electrostatically broken down. After the test circuit is damaged, it may cause an error judgment as to whether the screen body is qualified. This is quite disadvantageous for the production of the screen body.

KR 2015 0048364 A discloses a rectangular driving integrated circuit pad part having the driving integrated circuit of a flat display panel. The rectangular driving integrated circuit pad part includes: a first pad part which includes multiple first pads formed on one long side of the driving integrated circuit pad part, a second pad part which includes multiple second pads formed on the other long side of the driving integrated circuit pad part, and multiple test thin film transistors which are arranged between the first pad part and the second pad part and output test signals to the gate lines and data lines formed on a display part. A test driving circuit part having an organic layer is formed in the upper part of the test thin film transistors.

US 2002/191140 A1 discloses systems and methods to perform an electrical test on a substrate assembly used as a TFT array substrate of a liquid-crystal device without detaching a mounted external IC. The substrate assembly can include a substrate, a peripheral circuit embedded in the substrate, a first wiring arranged on the substrate, and an external IC, mounted on the substrate, and having a first on the first wiring. The substrate assembly can further include a second wiring which extends from the interconnection portion in such a manner that the second wiring is routed in a portion of the substrate facing the integrated circuit, and a first external circuit connection terminal arranged on the second wiring in a portion of the substrate not facing the integrated circuit. The external IC is thus tested through the external circuit connection terminal.

US 2016/379906 A1 discloses a display device which includes a display panel with signal wire pads connected to data lines; an integrated circuit (IC) that feeds a data voltage to the data lines; a multiplexer disposed on a substrate of the display panel, between the data lines and the integrated circuit; a flexible circuit board bonded onto the substrate of the display panel and connected to the signal wire pads; and a test circuit on the substrate of the display panel.

EP 3 376 350 A1 ,being an intermediate document according to Article54(3) EPC, discloses a display apparatus which includes a substrate including a display region and a non-display region, a display element layer, a pad group, a touch electrode layer, and a touch insulating layer. The display element layer includes display elements provided in the display region in a plan view. The pad group may include output pads provided on substrate and provided in the non-display region in the plan view. The touch electrode layer is provided on the display element layer. The touch insulating layer is provided on the display element layer and contacts the touch electrode layer. An intaglio pattern is provided in the touch insulating layer overlapped with the non-display region, and the intaglio pattern is not overlapped with the pad group.

JP 2006 053338 A discloses a liquid crystal display device which has a liquid crystal panel formed by bonding a pair of substrates with mutually different sizes together and an IC chip mounting region to mount the semiconductor element thereon arranged on an outer circumferential part of the substrate being the larger one out of the pair of substrates. A dummy pattern with a projecting and recessing surface is formed on the IC chip mounting region, and the semiconductor element is joined to the IC chip mounting region via anisotropic conductive adhesive members.

### SUMMARY

Based on the above, regarding the problem that the test circuit of circuit substrate is easily damaged, it is needed to provide a driving circuit board and a display device.

According to one aspect of the present invention, a display device comprising a driving circuit board is provided. The display device comprises a non-display region and a display region. The driving circuit board includes a substrate, a test circuit disposed on the substrate, the test circuit being formed in the non-display region of the display device between an input pad and an output pad of an integrated circuit chip, the input pad and the output pad being on either side of the test circuit, and a protective layer disposed on an upper surface of the test circuit and covering the test circuit. An upper surface of the protective layer comprises a rough region and a planar region, the planar region being located at a central region of the upper surface of the protective layer, the planar region being surrounded by the rough region, and the rough region at least partially covering the test circuit.

In the display device according to the above aspect of the present invention, the test circuit is covered by the protective layer. In this way, static electricity accumulation on the driving circuit can be avoided, thereby avoiding the thin film transistor of the test circuit being broken down. In this way, the test circuit is in an undamaged state, avoiding adverse effects on the screen test result caused by the damage of the test circuit, which facilitates the production of the screen body.

In one of the embodiments, the protective layer is made of organic material.

The protective layer made of an organic material has an adhesive property, which facilitates the covering and fixing of the protective layer to the surface of the test circuit. The strength property of the organic material prevents the test circuit from being damaged by external stress.

The rough region may increase a pasting area when the integrated circuit chip is pasted with the protective layer, and at the same time, the adhesion between the integrated circuit chip and the protective layer can be enhanced.

In one of the embodiments, the rough region is any one or a combination of corrugation structure, a plurality of protrusions, a plurality of pits staggered to each other and a mesh.

The combination of a plurality of structures can flexibly increase the area of the protective layer when pasting, so as to enhance the firmness of the pasting. The pits, the protrusions, or the corrugations can enhance adhesion between the integrated circuit chip and the protective layer.

When pasting the integrated circuit chip on the surface of the protective layer, more conductive adhesive is applied around the protective layer, while a small amount of conductive adhesive is applied in the planar region of the protective layer. In this way, not only can the integrated circuit chip be well fixed, but also the central region of the gate corresponding to the protective layer can be prevented from being excessively pressed downward.

In one of the embodiments, the driving circuit board further includes a display region thin film transistor array disposed on the substrate and having a planarization layer, and the protective layer is integrally formed with the planarization layer of the display region of the thin film transistor array.

Forming the protective layer integrally with the planarization layer of the thin film transistor array in the display region can reduce processes and improve work efficiency.

In one of the embodiments, the protective layer is made of inorganic material.

Inorganic materials have a certain strength, with certain wear resistance compressive resistance performances.

The substrate is further provided with the input pad and the output pad adjacent to the test circuit. The test circuit may transmit a test signal to the screen body through the input pad and the output pad.

The substrate is further provided with the input pad and the output pad located respectively on both sides of the protective layer. Preferably, the input pad and the output pad are disposed symmetrically on two sides of the protective layer. In one of the embodiments, a distance from an edge of the non-display region of the substrate to one side of the input pad or output pad is equal to a distance from another side of the respective input pad or output pad to a side of the protective layer close to the respective input pad or output pad.

The equidistant arrangement of the input pad or output pad and the protective layer can maintain the stress uniformity of the substrate, and the problem of imbalance stress on the integrated circuit chip when it is crimped may be avoided.

According to another aspect of the present invention, a method for manufacturing a display device comprising a driving circuit board is provided, the display device comprising a non-display region and a display region, the method comprising:
providing a substrate;
disposing a test circuit and a pair of connecting units on the substrate, the pair of connecting units acting as an input pad and an output pad of an integrated circuit chip respectively, the test circuit being formed in the non-display region of the display device between the input pad and the output pad of the integrated circuit chip, the input pad and the output pad being on either side of the test circuit;
disposing a protective layer on an upper surface of the test circuit and covering the test circuit; and
forming a rough region and a planar region on an upper surface of the protective layer, the planar region being located at a central region of the upper surface of the protective layer, the planar region being surrounded by the rough region, and the rough region at least partially covering the test circuit.

Optionally, the protective layer and the planarization layer of the display region are made of the same material, the disposing a protective layer on an upper surface of the test circuit comprising:
laying a planarization layer on the driving circuit board;
removing portions of the planarization layer corresponding to the two connecting units by etching; and
making the planarization layer on the test circuit form the protective layer.

Optionally, the protective layer is made of an inorganic material, the protective layer being formed by depositing a film layer of the inorganic material on the test circuit.

Thanks to the protective layer provided on the surface of the test circuit, the test circuit can have reliable operating performance, and the use of the display device will not be affected by the damage of the test circuit when the display device is in normal use, and thus the display device has a longer lifetime.

### BRIEF DESCRIPTION OF THE DRAWINGS

FIG. 1 is a structural schematic diagram of a display device according to one embodiment of the present invention.
FIG. 2 is a cross section schematic diagram of a driving circuit board according to an embodiment of the present invention.
FIG. 3 is a schematic diagram illustrating the positional relationship between a protective layer and a connecting unit in a driving circuit board according to an embodiment of the present invention.
FIG. 4 is a structural schematic diagram of a surface of a protective layer according to an embodiment, not being part of the claimed invention.
FIG. 5 is a structural schematic diagram of a surface of a protective layer according to the present invention.
FIG. 6 is a structural schematic diagram of a corrugated surface of a protective layer according to an embodiment of the present invention.

### DETAILED DESCRIPTION OF THE EMBODIMENTS

In order to make the purpose, technical scheme and technical effect of the invention more clear, the specific embodiments of the present invention are described below with reference to the accompanying drawings. It is to be understood that the specific embodiments described herein are merely used to illustrate the invention and are not intended to limit the invention.

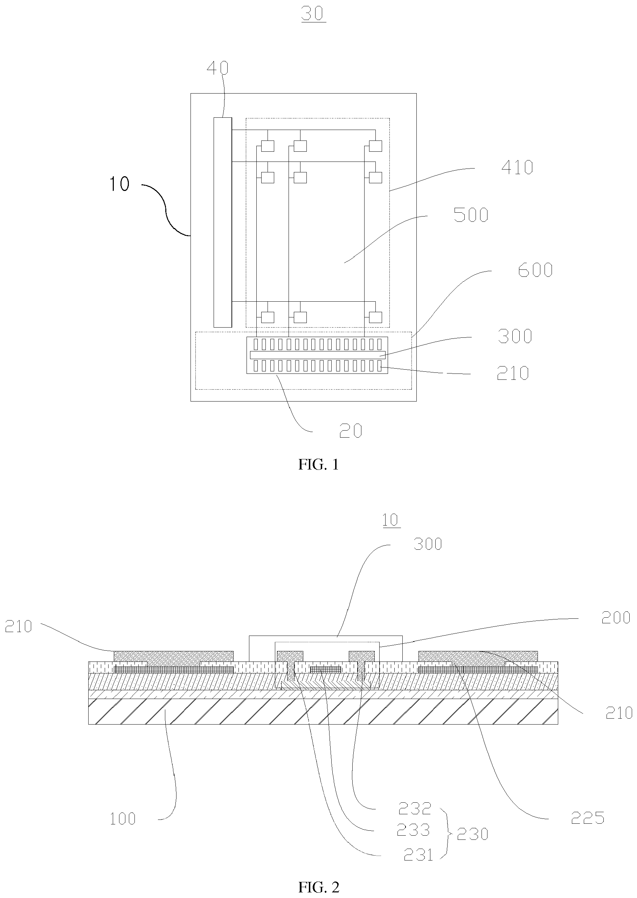

FIG. 1 illustrates a display device 30 according to one embodiment of the present invention. As shown in FIG. 1, the display device 30 includes a driving circuit board 10, and a data driving circuit 20, a scan driving circuit 40, and a display region thin film transistor array 410 provided on the driving circuit board 10. The display region thin film transistor array 410 is electrically connected to the data driving circuit 20 and the scan driving circuit 40. The data driving circuit 20 and the scan driving circuit 40 can control the operation of the display region thin film transistor array 410. The driving circuit board 10 includes a display region 500 and a non-display region 600. The display region thin film transistor array 410 is located in the display region 500. The non-display region 600 includes a protective layer 300 covering a test circuit (not shown), and a pair of connecting units 210 formed on both sides of the protective layer. The display region thin film transistor array 410 has a planarization layer integrally formed with the protective layer 300.

FIG. 2 illustrates a driving circuit board 10 according to one embodiment of the present invention. The driving circuit board 10 includes a substrate 100, a test circuit 200 disposed on the substrate 100, and a protective layer 300 disposed on an upper surface of the test circuit 200 and covering the test circuit 200. In conjunction with FIG. 1, the test circuit 200 is disposed in the non-display region 600.

The substrate 100 can be a glass substrate, a flexible plastic substrate, or a substrate made of other organic materials having a certain strength.

In one of the embodiments, the driving circuit board 10 further includes two connecting units 210 disposed in the non-display region 600 of the surface of the substrate 100. The two connecting units 210 are disposed respectively on two sides of the test circuit 200 and adjacent to the test circuit 200. In using, the two connecting units 210 act as an input pad and an output pad of an integrated circuit chip, respectively.

In one embodiment, the integrated circuit chip (not shown) could be electrically connected to the input pad and the output pad through input and output pins. The integrated circuit chip could be disposed above the test circuit 200. In such a way, the integrated circuit chip communicates with the driving circuit board 10 through the input pad, output pad, input pins and output pins, and controls the display device 30. In one embodiment, conductive adhesive is also coated among the input pad, output pad, input pins, and output pins, to therefore enhance an electrical connection among the input pad, output pad, input pins, and output pins, and facilitate the integrated circuit chip to be fixed above the test circuit 200.

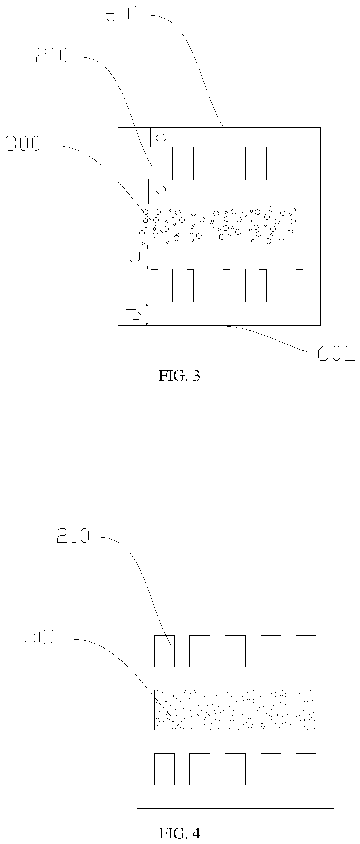

In one of the embodiments, the two connecting units 210 are disposed symmetrically on both sides of the test circuit 200. The symmetric arrangement of the connecting units 210 on both sides of the test circuit 200, the stress generated when the integrated circuit chip is depressed can be balanced, and the effect of the chip being depressed can be ensured, therefore, the service life of the substrate 100 is increased. In one preferred embodiment, as shown in FIG. 3, distances a, d respectively from the edge 601, 602 of the non-display region 600 to corresponding sides of the connecting unit 210 and the distances b, c respectively from the two connecting units 210 to the corresponding edges of the protective layer 300 are equal, i.e., a = b = c = d. The edges 601, 602 of the non-display region 600 could be boundaries of an organic glue layer, preferably formed together with the protective layer 300. It can be understood that the equidistant arrangement of the connecting units 210 and the test circuit 200 could maintain the substrate 100 stressed equably, and therefore, the substrate 100 can be more effectively prevented from being damaged due to non-uniform stress.

The test circuit 200 is used to test whether the display of the screen body is qualified. The test circuit 200 may be configured to test whether communication lines of the screen and/or pixels of the screen are damaged. Referring again to FIG. 2, the test circuit 200 may include a thin film transistor 230 including a source 231, a drain 232, and a gate 233, and an associated circuit. Through the test circuit 200, a test signal can be input to the screen body. The test circuit 200 includes a test unit. The test unit could be connected to the thin film transistor 230 via a plurality of signal channels. The test circuit 200 is used as follows: the test unit supplies a gate-on voltage to the gate 233 to turn on the source 231 and the drain 232, and the thin film transistor 230 is turned on. Then, a test signal is input from the test unit to the screen body via the thin film transistor 230 to test whether the communication lines of the screen body and the display pixels of the screen body are damaged.

In order to ensure that the thin film transistor 230 and the conductive lines in the test circuit 200 are undamaged, when the test circuit 200 has been manufactured, a protective layer 300 covering the test circuit 200 is formed over the test circuit 200. The protective layer 300 is configured to protect the test circuit 200. For example, the test circuit 200 is isolated from the external environment, thereby avoiding accumulating static electricity at the thin film transistor 230 of the test circuit 200, to prevent the thin film transistor 230 from being electrostatically broken down. Electrostatic breakdown can cause damage to the test circuit 200, thereby causing trouble for subsequent work. For example, when the thin film transistor 230 is broken down, the test result of the screen body will be adversely affected and the screen body may be erroneously judged as to whether it is qualified. Further, a more complicated reexamination step is required in a subsequent step to find a qualified screen from the screens being misjudged as unqualified screens. Additionally, the protective layer 300 may protect the test circuit 200 from accidental corrosion so as to ensure normal function of the test circuit 200 during test.

In one embodiment, the protective layer 300 may be made of an organic material or an inorganic material. In one preferred embodiment, the protective layer 300 may be made of a material same to that of the planarization layer of the display region 500. In another embodiment, the protective layer 300 can be made from SiOx film or SiNₓ film. In the case where the protective layer 300 is formed of organic materials, the protective layer 300 may also have a certain buffering performance, such that the damage to the test circuit 200 caused by excessive stress from the integrated circuit chip on the surface of the test circuit 200 or on the protective layer 300 may be avoided. In one embodiment, the protective layer 300 has a thickness from 1.5 mm to 2 mm. The protective layer 300 with a thickness of 1.5 mm to 2 mm can not only solve the static electricity problem in the test circuit 200, but also has a sufficient buffering performance.

Preferably, the conductive adhesive is disposed between the protective layer 300 and the integrated circuit chip to further fix the integrated circuit chip. In one embodiment shown in FIG. 4, not according to the claimed invention, there is a rough region on the surface of the protective layer 300 away from the substrate 100. For example, when the protective layer 300 is formed of organic materials, the rough region or a mesh can be formed by photolithography; when the protective layer 300 is formed of inorganic materials, the rough region can be formed by etching the protective layer 300. In another embodiment, the rough region can be formed by either one or combination of pits, protrusions, arranged densely, gullies or corrugation structures staggered to each other. In fact, the rough region can be constructed in any other suitable form. The lower surface of the integrated circuit chip can be bonded or pasted together with the rough region of the protective layer 300 during the integrated circuit chip assembling process. In this way, the rough region may increase the bonding force between the integrated circuit chip and the protective layer 300, so that the integrated circuit chip and the protective layer 300 are firmly attached.

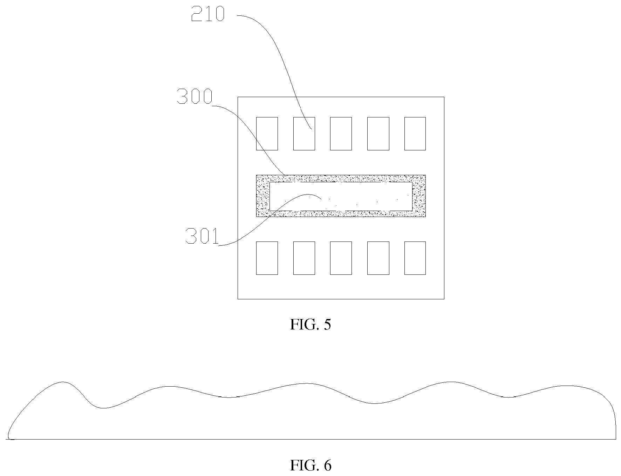

The location of the rough region can be adjusted according to that different locations of the test circuit 200 have different stresses applied on. In an example not covered by the invention, the rough region can be formed as the entire outer surface of the protective layer 300. In an example covered by the invention, the rough region is formed as a partial region of the outer surface of the protective layer 300. The rough region is disposed around the protective layer 300. Referring to FIG. 5, according to the claimed invention,

the central region of the protective layer 300 is a planar region 301, and the surrounding portion is the rough region. When pasting the integrated circuit chip on the surface of the protective layer 300, a method of more conductive adhesive used around the protective layer 300 and less adhesive used in the planar region 301 of the protective layer 300 can not only well fix the integrated circuit chip, but also prevent the central region of the gate 233 corresponding to the protective layer 300 from being excessively pressed down. In this way, the amount of the conductive adhesive is reduced, and the thin film transistor 230 is protected.

In the embodiment shown in FIG. 6, the rough surface of the outer surface of the protective layer 300 is in corrugation structure. In the case that the protective layer 300 is formed of organic materials, the rough region in the form of corrugation structures is preferable. The reason is that the configuration of the corrugation structures can be relatively gentle, the using amount of conductive adhesive can be reduced, and the purpose of pasting the integrated circuit chip and the protective layer 300 firmly can be achieved.

In one embodiment, the test circuit 200 is electrically connected to circuit of the display region 500. The protective layer 300 covering the surface of the test circuit 200 can prevent the test circuit 200 from being corroded or damaged. During the process of the producing the driving circuit board 10, there are other manufacturing processes after the test circuit 200 is produced. The test circuit 200 can be prevented from being scratched or corroded by other chemical agents in other manufacturing processes, due to the protective layer 300. Therefore, an open circuit phenomenon will not occur in the test circuit 200, and there is no misjudgment caused by the damage of the test circuit when the screen is tested.

The protective layer 300 can be formed in the following way.

When the protective layer 300 and the planarization layer of the display region 500 are made of the same material, the forming process of the protective layer 300 may be: laying a planarization layer on the display region 500 and the non-display region 600; then removing portions of the planarization layer corresponding to two connecting units 210 by etching. In this way, the planarization layer on the test circuit 200 forms the protective layer 300. It can be understood that the rough region on the protective layer 300 can also be formed by means of etching.

When the protective layer 300 is formed of inorganic materials, the protective layer 300 can be formed by depositing a film layer of an inorganic material on the test circuit 200.

The above are embodiments of the disclosure described in detail, and should not be deemed as limitations to the scope of the present disclosure. It should be noted that variations and improvements will become apparent to those skilled in the art to which the present disclosure pertains without departing from its scope. Therefore, the scope of the present disclosure is defined by the appended claims.

## Claims

1. A display device (30) comprising a driving circuit board (10), the display device (30) comprising a non-display region (600) and a display region (500), and the driving circuit board (10) including:
a substrate (100);
a test circuit (200) disposed on the substrate (100), the test circuit (200) being formed in the non-display region (600) of the display device (30) between an input pad (210) and an output pad (210) of an
integrated circuit chip, the input pad and the output pad being on either side of the test circuit (200); and
a protective layer (300) disposed on an upper surface of the test circuit (200) and covering the test circuit (200),
**characterized in that** an upper surface of the protective layer (300) comprises a rough region and a planar region (301), the planar region (301) being located at a central region of the upper surface of the protective layer (300), the planar region (301) being surrounded by the rough region, and the rough region at least partially covering the test circuit (200).

2. The display device (30) of claim 1, wherein the protective layer (300) is made of organic material.

3. The display device (30) of claim 1, wherein the rough region is one of or a combination of corrugation structure, a plurality of protrusions, a plurality of pits staggered to each other and a mesh.

4. The display device (30) of any one of claims 1 to 3, further comprising a display region thin film transistor array (410) disposed on the substrate (100) and having a planarization layer, the protective layer (300) being integrally formed with the planarization layer of the display region of the thin film transistor array (410).

5. The display device (30) of claim 3, wherein the protective layer (300) is made of inorganic material.

6. The display device (30) of claim 1, wherein the input pad (210) and the output pad (210) are located on two sides of the protective layer (300).

7. The display device (30) of claim 6, wherein the input pad (210) and the output pad (210) are disposed symmetrically on both sides of the protective layer (300).

8. The display device (30) of any one of claims 6 to 7 wherein a distance from an edge of the non-display region (600) of the substrate to one side of the input pad or output pad (210) is equal to a distance from another side of the respective input pad or output pad (210) to a side of the protective layer (300) close to the respective input pad or output pad (210).

9. A method for manufacturing a display device (30) comprising a driving circuit board (10), the display device (30) comprising a non-display region (600) and a display region (500), the method comprising:
providing a substrate (100);
disposing a test circuit (200) and a pair of connecting units (210) on the substrate (100), the pair of connecting units (210) acting as an input pad and an output pad of an integrated circuit chip respectively, the test circuit (200) being formed in the non-display region (600) of the display device (30) between the input pad and the output pad of the integrated circuit chip, the input pad and the output pad being on either side of the test circuit (200);
disposing a protective layer (300) on an upper surface of the test circuit (200) and covering the test circuit (200);
**characterized by** forming a rough region and a planar region (301) on an upper surface of the protective layer (300), the planar region (301) being located at a central region of the upper surface of the protective layer (300), the planar region (301) being surrounded by the rough region, and the rough region at least partially covering the test circuit (200).

10. The method of claim 9, **characterized in that** a planarization layer is formed on the display region (500) of the display device (30), and the protective layer (300) and the planarization layer of the display region (500) are made of the same material,
the disposing a protective layer (300) on the upper surface of the test circuit (200) comprising:
laying a planarization layer on the driving circuit board (10), the planarization layer covering an upper surface of the display region (500) and the upper surface of the test circuit (200);
removing portions of the planarization layer corresponding to the two connecting units (210) by etching; and
making the planarization layer on the test circuit (200) form the protective layer (300).

11. The method of claim 9 , **characterized in that** the protective layer (300) is made of an inorganic material, the protective layer (300) being formed by depositing a film layer of the inorganic material on the test circuit (200).

## Patentansprüche

1. Anzeigevorrichtung (30) mit einer Treiberplatine (10), wobei die Anzeigevorrichtung (30) einen Nicht-Anzeigebereich (600) und einen Anzeigebereich (500) aufweist, und wobei die Treiberplatine (10) Folgendes aufweist:
einen Träger (100);
einen auf dem Träger (100) angeordneten Prüfkreis (200), wobei der Prüfkreis (200) in dem Nicht-Anzeigebereich (600) der Anzeigevorrichtung (30) zwischen einem Eingabefeld (210) und einem Ausgabefeld (210) eines Schaltkreis-Chips ausgebildet ist, wobei sich das Eingabefeld und das Ausgabefeld auf beiden Seiten des Prüfkreises (200) befinden; und
eine Schutzschicht (300), die auf einer Oberfläche des Prüfkreises (200) angeordnet ist und den Prüfkreis (200) bedeckt,
**dadurch gekennzeichnet, dass** eine obere Fläche der Schutzschicht (300) einen rauen Bereich und einen ebenen Bereich (301) aufweist, wobei sich der ebene Bereich (301) in einem mittigen Bereich der Oberfläche der Schutzschicht (300) befindet, wobei der ebene Bereich (301) von dem rauen Bereich umgeben ist, und wobei der raue Bereich zumindest teilweise den Prüfkreis (200) bedeckt.

2. Anzeigevorrichtung (30) nach Anspruch 1, wobei die Schutzschicht (300) aus einem organischen Material besteht.

3. Anzeigevorrichtung (30) nach Anspruch 1, wobei der raue Bereich aus einem oder einer Kombination der Folgenden besteht: einer Wellenstruktur, einer Vielzahl von Vorsprüngen, einer Vielzahl von zueinander versetzten Vertiefungen und einem Netz.

4. Anzeigevorrichtung (30) nach einem der Ansprüche 1 bis 3, weiterhin mit einer Dünnschicht-Transistoranordnung des Anzeigebereiches (410), die auf dem Träger (100) angeordnet ist und eine Planarisierungsschicht aufweist, wobei die Schutzschicht (300) einstückig mit der Planarisierungsschicht des Anzeigebereichs der Dünnschicht-Transistoranordnung (410) ausgebildet ist.

5. Anzeigevorrichtung (30) nach Anspruch 3, wobei die Schutzschicht (300) aus einem anorganischen Material besteht.

6. Anzeigevorrichtung (30) nach Anspruch 1, wobei das Eingabefeld (210) und das Ausgabefeld (210) auf zwei Seiten der Schutzschicht (300) liegen.

7. Anzeigevorrichtung (30) nach Anspruch 6, wobei das Eingabefeld (210) und das Ausgabefeld (210) symmetrisch auf beiden Seiten der Schutzschicht (300) angeordnet sind.

8. Anzeigevorrichtung (30) nach einem der Ansprüche 6 bis 7, wobei ein Abstand von einem Rand des Nicht-Anzeigebereichs (600) des Trägers zu einer Seite des Eingabefeldes oder Ausgabefeldes (210) gleich einem Abstand von einer anderen Seite des jeweiligen Eingabefeldes oder Ausgabefeldes (210) zu einer Seite der Schutzschicht (300) in der Nähe des jeweiligen Eingabefelds oder Ausgabefelds (210) ist.

9. Verfahren zur Herstellung einer Anzeigevorrichtung (30) mit einer Treiberplatine (10), wobei die Anzeigevorrichtung (30) einen Nicht-Anzeigebereich (600) und einen Anzeigebereich (500) aufweist, wobei das Verfahren folgende Schritte aufweist:
Bereitstellen eines Trägers (100);
Anordnen eines Prüfkreises (200) sowie eines Paars von Verbindungseinheiten (210) auf dem Träger (100), wobei das Paar von Verbindungseinheiten (210) jeweils als ein Eingabefeld und ein Ausgabefeld eines Schaltkreis-Chips fungiert, wobei der Prüfkreis (200) in dem Nicht-Anzeigebereich (600) der Anzeigevorrichtung (30) zwischen dem Eingabefeld und dem Ausgabefeld des Schaltkreis-Chips ausgebildet ist, wobei sich das Eingabefeld und das Ausgabefeld auf beiden Seiten des Prüfkreises (200) befinden;
Anordnen einer Schutzschicht (300) auf einer oberen Fläche des Prüfkreises (200) und Bedecken des Prüfkreises (200);
**gekennzeichnet durch** das Ausbilden eines rauen Bereichs und eines ebenen Bereichs (301) auf einer oberen Fläche der Schutzschicht (300), wobei der ebene Bereich (301) an einem mittigen Bereich der oberen Fläche der Schutzschicht (300) liegt, wobei der ebene Bereich (301) von dem rauen Bereich umgeben ist und wobei der raue Bereich zumindest teilweise den Prüfkreis (200) umgibt.

10. Verfahren nach Anspruch 9,
**dadurch gekennzeichnet, dass** eine Planarisierungsschicht auf dem Anzeigebereich (500) der Anzeigevorrichtung (30) gebildet wird, und die Schutzschicht (300) und die Planarisierungsschicht des Anzeigebereichs (500) aus demselben Material bestehen,
wobei das Anordnen einer Schutzschicht (300) auf der oberen Fläche des Prüfkreises (200) Folgendes aufweist:
Aufbringen einer Planarisierungsschicht auf die Treiberplatine (10), wobei die Planarisierungsschicht eine obere Fläche des Anzeigebereichs (500) und die obere Fläche des Prüfkreises (200) bedeckt;
Entfernen von Abschnitten der Planarisierungsschicht entsprechend den zwei Verbindungseinheiten (210) durch Ätzen; und
Ausbilden der Schutzschicht (300) auf dem Prüfkreis (200) durch die Planarisierungsschicht.

11. Verfahren nach Anspruch 9,
**dadurch gekennzeichnet, dass** die Schutzschicht (300) aus einem anorganischen Material besteht, wobei die Schutzschicht (300) durch Aufbringen einer Folienschicht aus dem anorganischen Material auf den Prüfkreis (200) gebildet wird.

## Revendications

1. Dispositif d'affichage (30) comprenant une carte de circuit de commande (10), le dispositif d'affichage (30) comprenant une région de non-affichage (600) et une région d'affichage (500), et la carte de circuit de commande (10) comportant :
un substrat (100) ;
un circuit de test (200) disposé sur le substrat (100), le circuit de test (200) étant formé dans la région de non-affichage (600) du dispositif d'affichage (30) entre une pastille d'entrée (210) et une pastille de sortie (210) d'une puce de circuit intégré, la pastille d'entrée et la pastille de sortie étant de chaque côté du circuit de test (200) ; et
une couche de protection (300) disposée sur une surface supérieure du circuit de test (200) et recouvrant le circuit de test (200),
**caractérisé en ce qu'**une surface supérieure de la couche de protection (300) comprend une région rugueuse et une région plane (301), la région plane (301) étant située à une région centrale de la surface supérieure de la couche de protection (300), la région plane (301) étant entourée par la région rugueuse, et la région rugueuse recouvrant au moins partiellement le circuit de test (200).

2. Dispositif d'affichage (30) selon la revendication 1, dans lequel la couche de protection (300) est constituée d'un matériau organique.

3. Dispositif d'affichage (30) selon la revendication 1, dans lequel la région rugueuse est l'une ou une combinaison d'une structure ondulée, une pluralité de saillies, une pluralité de creux échelonnés l'un par rapport à l'autre et un maillage.

4. Dispositif d'affichage (30) selon l'une quelconque des revendications 1 à 3, comprenant en outre un réseau de transistors à films minces de région d'affichage (410) disposé sur le substrat (100) et comportant une couche d'aplanissement, la couche de protection (300) étant formée d'un seul tenant avec la couche d'aplanissement de la région d'affichage du réseau de transistors à films minces (410).

5. Dispositif d'affichage (30) selon la revendication 3, dans lequel la couche de protection (300) est constituée d'un matériau inorganique.

6. Dispositif d'affichage (30) selon la revendication 1, dans lequel la pastille d'entrée (210) et la pastille de sortie (210) sont situées sur deux côtés de la couche de protection (300).

7. Dispositif d'affichage (30) selon la revendication 6, dans lequel la pastille d'entrée (210) et la pastille de sortie (210) sont disposées symétriquement des deux côtés de la couche de protection (300).

8. Dispositif d'affichage (30) selon la revendication 6 ou 7, dans lequel une distance depuis un bord de la région de non-affichage (600) du substrat jusqu'à un côté de la pastille d'entrée ou de la pastille de sortie (210) est égale à une distance depuis un autre côté de la pastille d'entrée ou de la pastille de sortie (210) respective jusqu'à un côté de la couche de protection (300) proche de la pastille d'entrée ou de la pastille de sortie (210) respective.

9. Procédé de fabrication d'un dispositif d'affichage (30) comprenant une carte de circuit de commande (10), le dispositif d'affichage (30) comprenant une région de non-affichage (600) et une région d'affichage (500), le procédé comprenant :
la fourniture d'un substrat (100) ;
la disposition d'un circuit de test (200) et d'une paire d'unités de liaison (210) sur le substrat (100), la paire d'unités de liaison (210) agissant respectivement en tant qu'une pastille d'entrée et une pastille de sortie d'une puce de circuit intégré, le circuit de test (200) étant formé dans la région de non-affichage (600) du dispositif d'affichage (30) entre la pastille d'entrée et la pastille de sortie de la puce de circuit intégré, la pastille d'entrée et la pastille de sortie étant de chaque côté du circuit de test (200) ;
la disposition d'une couche de protection (300) sur une surface supérieure du circuit de test (200) et recouvrant le circuit de test (200) ;
**caractérisé par** la formation d'une région rugueuse et d'une région plane (301) sur une surface supérieure de la couche de protection (300), la région plane (301) étant située à une région centrale de la surface supérieure de la couche de protection (300), la région plane (301) étant entourée par la région rugueuse, et la région rugueuse recouvrant au moins partiellement le circuit de test (200).

10. Procédé selon la revendication 9, **caractérisé en ce qu'**une couche d'aplanissement est formée sur la région d'affichage (500) du dispositif d'affichage (30), et la couche de protection (300) et la couche d'aplanissement de la région d'affichage (500) sont constituées du même matériau,
la disposition d'une couche de protection (300) sur la surface supérieure du circuit de test (200) comprenant :
la pose d'une couche d'aplanissement sur la carte de circuit de commande (10), la couche d'aplanissement recouvrant une surface supérieure de la région d'affichage (500) et la surface supérieure du circuit de test (200) ;
le retrait de parties de la couche d'aplanissement correspondant aux deux unités de liaison (210) par gravure ; et
l'étape consistant à amener la couche d'aplanissement sur le circuit de test (200) à former la couche de protection (300).

11. Procédé selon la revendication 9, **caractérisé en ce que** la couche de protection (300) est constituée d'un matériau inorganique, la couche de protection (300) étant formée par le dépôt d'une couche de film du matériau inorganique sur le circuit de test (200).
